# EUROPEAN PATENT APPLICATION

(11) **EP 4 207 277 A1**
(43) Date of publication of application: **05.07.2023**
(21) Application number: 21886558.2
(22) Date of filing: 15.09.2021
(51) Int. Cl.: H01L 25/075, H01L 27/12, H01L 25/16

(54) **DISPLAY MODULE AND MANUFACTURING METHOD THEREFOR**

(30) Priority: 27.10.2020 KR 20200140149
(71) Applicant: Samsung Electronics Co., Ltd., Suwon-si, Gyeonggi-do 16677 (KR)
(72) Inventor: HAN, Seungryong, Suwon-si Gyeonggi-do 16677 (KR); KIM, Hyunsun, Suwon-si Gyeonggi-do 16677 (KR); SON, Yangsoo, Suwon-si Gyeonggi-do 16677 (KR); CHO, Jinhyun, Suwon-si Gyeonggi-do 16677 (KR); HAN, Jeongin, Suwon-si Gyeonggi-do 16677 (KR)
(74) Representative: Appleyard Lees IP LLP
(86) International application number: PCT/KR2021/012592
(87) International publication number: WO 2022/092564

(57) **Abstract**

A display module includes a substrate; a thin film transistor (TFT) layer which is stacked on a front surface of the substrate, and on which a plurality of TFT electrodes are arranged on the TFT layer; a plurality of light emitting diodes electrically connected to a plurality of TFT electrodes; an anti-reflection layer which is stacked on the TFT layer, has a light-absorbing color that absorbs external light, and fixes in place the plurality of light emitting diodes; and a protective layer stacked on the anti-reflection layer and the plurality of light emitting diodes. The plurality of TFT electrodes and the plurality of light emitting diodes are electrically connected to each other in the anti-reflection layer.

## Description

### [TECHNICAL FIELD]

The disclosure relates to a display module and a manufacturing method therefor, and more particularly, to a display module and a manufacturing method therefor, capable of minimizing reflection of external light.

### CROSS-REFERENCE TO RELATED APPLICATIONS

This application claims priority based on Korean Patent Application No. 10-2020-0140149 filed on October 27, 2020, and all contents of the application are incorporated herein by reference in their entirety.

### [BACKGROUND ART]

A self-luminous display device displays an image without a backlight, and may use a micro LED that emits light by itself.

The display module is operated in units of pixels or sub-pixels including micro LEDs to express various colors. Each pixel or sub-pixel is controlled by a plurality of thin film transistors (TFTs). The plurality of TFTs are arranged on a flexible substrate, a glass substrate, or a plastic substrate, which is called a TFT substrate. A plurality of display modules may be connected to manufacture a large display device.

### [DISCLOSURE]

### [TECHNICAL PROBLEM]

The disclosure provides a display module capable of expressing true black by improving a contrast ratio of a display by minimizing reflection of external light, and a manufacturing method therefor.

The disclosure also provides a display module capable of blocking radiant heat due to LED light emission and TFT driving without loss of transmittance, and a manufacturing method therefor.

### [TECHNICAL SOLUTION]

According to an embodiment of the disclosure, a display module includes: a substrate; a thin film transistor (TFT) layer stacked on a surface of the substrate, and on which a plurality of TFT electrodes are arranged on the TFT layer; a plurality of light emitting devices (LEDs) electrically connected to the plurality of TFT electrodes; an anti-reflection layer stacked on the TFT layer, the anti-reflection layer having a light absorption color for absorbing external light, the anti-reflection layer fixing in place the plurality of LEDs; and a protective layer stacked on the anti-reflection layer and the plurality of LEDs. The plurality of TFT electrodes and the plurality of LEDs may be electrically connected in the anti-reflection layer.

The anti-reflection layer may be formed by applying a black-based pigment or dye to an anisotropic conductive film (ACF).

The anti-reflection layer may be formed by applying a black-based pigment or dye to a non-conductive film (NCF).

The anti-reflection layer may be formed of a black resin.

The plurality of LEDs may have a light emitting surface exposed to the outside of the anti-reflection layer.

A portion of the plurality of LEDs in which the light emitting surface is formed may protrude from the anti-reflection layer.

Each of the plurality of LEDs may include a pair of LED electrodes formed on a lower portion opposite to an upper portion on which the light emitting surface is formed, and the pair of LED electrodes may be embedded in the anti-reflection layer together with the plurality of TFT electrodes.

The display module may further include a molding layer covering the anti-reflection layer and the plurality of LEDs, and the protective layer may be stacked on the molding layer.

The display module may further include an ultra-low reflection layer stacked on the protective layer. The display module may further include a radiant heat blocking layer stacked on the ultra-low reflection layer to block near-infrared and far-infrared rays. The protective layer may have a plurality of diffuse reflection protrusions formed on a surface thereof.

According to another embodiment of the disclosure, a display module may include: a thin film transistor (TFT) substrate; an anti-reflection layer stacked on the TFT layer and having a black-based color; a plurality of LEDs each respectively electrically connected to a corresponding one of the plurality of TFT electrodes of the TFT layer through the anti-reflection layer; and a molding layer stacked on the anti-reflection layer and the plurality of LEDs. Each of the plurality of LEDs may include a light emitting surface formed on an upper portion thereof, and a pair of LED electrodes disposed on a lower portion opposite to upper portion, and the pair of LED electrodes may be electrically connected to a pair of TFT electrodes, among the plurality of TFT electrodes, in the anti-reflection layer.

The display module may further include a protective layer stacked on the anti-reflection layer and the plurality of LEDs; and an ultra-low reflection layer stacked on the protective layer. The display module may further include a radiant heat blocking layer stacked on the ultra-low reflection layer to block near-infrared and far-infrared rays. The protective layer may have a plurality of diffuse reflection protrusions formed on the surface.

According to another embodiment of the disclosure, a method of manufacturing a display module may include: stacking an anti-reflection layer having a black-based color on a thin film transistor (TFT) layer formed on a substrate; transferring a plurality of LEDs to the TFT layer; thermally compressing the plurality of LEDs toward the TFT layer to respectively electrically connect electrodes of the plurality of LEDs to corresponding TFT electrodes provided on the TFT layer, a pair of electrodes of each of the plurality of LEDs being thereby inserted into the anti-reflection layer and electrically connected to the TFT electrode, the plurality of LEDs being thereby fixed in place by the anti-reflection layer; covering the plurality of LEDs with an adhesive encapsulating member; and stacking a protective layer on the plurality of LEDs and the anti-reflection layer.

The method of manufacturing a display module may further include removing a portion of the anti-reflection layer with a laser beam before transferring the plurality of LEDs, to expose an alignment mark marked on the TFT layer.

The method of manufacturing a display module may further include irradiating the anti-reflection layer with a laser beam before transferring the plurality of LEDs, to form an alignment mark pattern recognizable by a vision camera.

The anti-reflection layer may be formed to have a transmittance so that the alignment mark marked on the TFT layer is recognizable by the vision camera.

### [DESCRIPTION OF DRAWINGS]

FIG. 1 is a plan view schematically illustrating a display module according to an embodiment of the disclosure;
FIG. 2 is a view illustrating an example arrangement of a plurality of sub-pixels mounted in the pixel area shown in FIG. 1;
FIG. 3 is a cross-sectional view schematically illustrating a display module according to an embodiment of the disclosure;
FIG. 4 is an enlarged view illustrating a portion of the display module shown in FIG. 3;
FIG. 5 is a flowchart illustrating a manufacturing process of a display module according to an embodiment of the disclosure;
FIG. 6 is a view schematically illustrating an example of stacking a thin film transistor (TFT) layer on a glass substrate;
FIG. 7 is a view schematically illustrating an example of stacking an anti-reflection layer on a TFT layer;
FIG. 8 is a view schematically illustrating an example of transferring a plurality of micro LEDs onto an anti-reflection layer;
FIG. 9 is a view illustrating an example of thermally compressing a plurality of micro LEDs by a pressing member to be electrically connected to a plurality of TFT electrodes;
FIG. 10 is a view illustrating an example of forming a protective layer covering an anti-reflection layer and a plurality of micro LEDs;
FIG. 11 is a view illustrating an example of forming an ultra-low reflection layer on the protective layer;
FIG. 12 is a view illustrating an example of forming a radiant heat blocking layer on an ultra-low reflection layer;
FIG. 13 is a view illustrating an example of forming a plurality of diffuse reflection protrusions in order to maximize an anti-reflection effect; and
FIG. 14 is a view illustrating an example of forming fine alignment marks on an anti-reflection layer with a laser beam.

### [BEST MODE]

Hereinafter, various embodiments will be described in detail with reference to the accompanying drawings. The embodiments described herein may be variously modified. Specific embodiments may be illustrated in the drawings and described in detail in the detailed description. It should be understood, however, that the specific embodiments disclosed in the accompanying drawings are intended only to facilitate understanding of various embodiments. Therefore, the technical idea is not limited by the specific embodiments disclosed in the accompanying drawings but includes all equivalents or alternatives falling within the spirit and scope of the disclosure.

Terms including ordinals, such as first, second, etc., may be used to describe various elements but such elements are not limited to the above terms. The above terms are used only for the purpose of distinguishing one component from another.

In this specification, the terms "comprise" or "have" and the like, are intended to specify the presence of stated features, integers, steps, operations, elements, parts, or combinations thereof, but do not preclude the presence or addition of one or more other features, integers, steps, operations, elements, components, or combinations thereof. It is to be understood that when an element is referred to as being "connected" to another element, it may be directly on or directly connected to the other element or layer, or intervening elements or layers may be present. Meanwhile, when an element is referred to as being "directly connected" to another element, it should be understood that there are no other elements in between.

In the disclosure, the expression 'the same' means not only to completely match, but also includes a degree of difference in consideration of a processing error range.

In addition, in the description of the disclosure, when it is determined that a detailed description of known functions or components related thereto may unnecessarily obscure the gist of the disclosure, the detailed description thereof will be abbreviated or omitted.

In the disclosure, the display module may be a display panel including a micro light emitting diode (LED). The display module is one of the flat panel display panels and includes a plurality of inorganic LEDs each having a size of 100 micrometers or less. Compared to liquid crystal display (LCD) panels that require backlight, micro LED display modules offer better contrast, response time, and energy efficiency. Both organic LEDs and micro LEDs, which are inorganic light emitting devices, have high energy efficiency, but micro LEDs have better brightness and luminous efficiency and longer lifespan than OLEDs. A micro LED may be a semiconductor chip that may emit light by itself when power is supplied thereto. Micro LEDs have a fast response speed, low power, and high luminance. Specifically, the micro LEDs have a higher efficiency of converting electricity into photons than existing liquid crystal displays (LCD) or OLEDs. In other words, micro LEDs have a higher "brightness per watt" than the existing LCDs or OLED displays. Accordingly, the micro LEDs may produce the same brightness even with about half the energy compared to existing LEDs (having width, length, and height each exceeding 100 µm) or OLEDs. In addition, micro LEDs may realize high resolution, excellent color, contrast, and brightness, so it may accurately express a wide range of colors, and may implement a clear screen even in bright sunlight. In addition, the micro LEDs are strong against a burn-in phenomenon and have low heat generation, thereby guaranteeing a long lifespan without deformation.

In the disclosure, the micro LED may have a flip chip structure in which anode and cathode electrodes are formed on the same first surface and a light emitting surface is formed on a second surface opposite to the first surface on which the electrodes are formed.

In the disclosure, a glass substrate may include a TFT layer having a thin film transistor (TFT) circuit formed on a front surface and a circuit disposed on a rear surface to supply power to the TFT circuit and electrically connected to a separate control substrate. The TFT circuit may drive a number of pixels disposed in the TFT layer.

In the disclosure, the front surface of the glass substrate may be divided into an active area and a dummy area. The active area may correspond to a region occupied by the TFT layer on the front surface of the glass substrate, and the dummy area may be a region excluding the region occupied by the TFT layer on the front surface of the glass substrate.

In the disclosure, an edge region of the glass substrate may be the outermost portion of the glass substrate. Also, the edge region of the glass substrate may be a region remaining except for a region in which a circuit of the glass substrate is formed. Also, the edge region of the glass substrate may include a side surface of the glass substrate, a front portion of the glass substrate adjacent to the side surface, and a portion of a rear surface of the glass substrate. The glass substrate may be formed to have a quadrangle type. Specifically, the glass substrate may be formed to have a rectangular shape or a square shape. The edge region of the glass substrate may include at least one side of the four sides of the glass substrate.

In the disclosure, a plurality of side wirings may be formed at regular intervals in the edge region of the glass substrate. The plurality of side wirings may have one end electrically connected to a plurality of first connection pads formed in the edge region included in the front surface of the glass substrate, and the other ends electrically connected to a plurality of second connection pads formed in the edge region included in the rear surface of the glass substrate. The plurality of first connection pads may be connected to the TFT circuit disposed on the front surface of the glass substrate through wirings, and the plurality of second connection pads may be connected to a driving circuit disposed on the rear surface of the glass substrate through wirings.

In the disclosure, as described above, when the substrate is a glass substrate, a TFT layer may be formed on one surface of the glass substrate, and if the substrate is a board formed of a synthetic resin material, the TFT layer may be formed on both surfaces of the board.

In the disclosure, in the display module, as the plurality of side wirings are formed, the dummy area may be minimized in the front surface of the TFT substrate and the active area may be maximized, thereby obtaining a bezel-less configuration and increasing a mounting density of the micro LEDs for the display module. By connecting a plurality of display modules implementing a bezel-less configuration, a large format display (LFD) device capable of maximizing the active area may be provided. In this case, as the dummy area is minimized, pitches between the pixels of the display modules adjacent to each other may be maintained to be equal to pitches between pixels in a single display module. Accordingly, appearance of a seam in a connection portion between the display modules may be prevented.

In the disclosure, an example in which a plurality of side wirings are formed at regular intervals in edge regions corresponding to two sides facing each other among edge regions corresponding to four sides of the glass substrate is described. However, the disclosure is not limited thereto, and a plurality of side wirings may be formed at regular intervals in edge regions corresponding to two sides adjacent to each other. In addition, in the disclosure, a plurality of side wirings are formed at regular intervals in only an edge region corresponding to one of the edge regions corresponding to the four sides, as necessary, but a plurality of side wirings may be formed at regular intervals in the edge regions corresponding to the three sides.

In the disclosure, the display module includes a glass substrate on which a plurality of LEDs are mounted and a side wiring is formed. Such a display module may be installed in and applied to wearable devices, portable devices, handheld devices, and electronic products or electric devices that require various displays, as a single unit, and may be applied to display devices such as monitors for personal computers (PCs), high-resolution TVs, and signages (or digital signages), electronic displays, as a matrix type through multiple assembly arrangements.

Hereinafter, a display module according to an embodiment of the disclosure will be described with reference to the drawings.

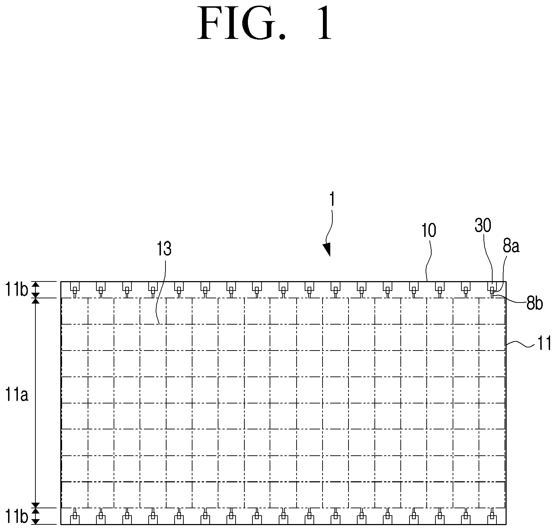

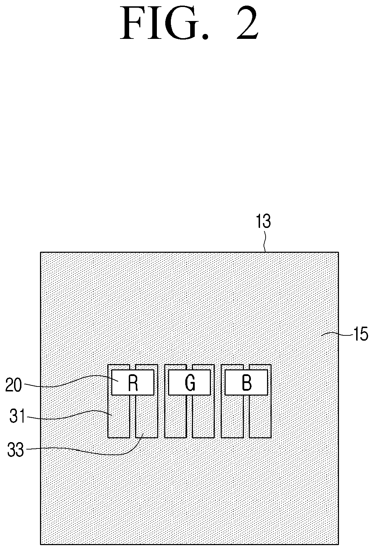

FIG. 1 is a plan view schematically illustrating a display module according to an embodiment of the disclosure, and FIG. 2 is a cross-sectional view schematically illustrating a display module according to an embodiment of the disclosure.

Referring to FIGS. 1 and 2, a display module 1 may include a TFT substrate 12 and a plurality of micro LEDs 20 transferred onto the TFT substrate 12 to form a plurality of pixels.

The TFT substrate 12 may include a glass substrate 10, a TFT layer 11 including a TFT circuit on a front surface of the glass substrate 10, and a plurality of side wirings 30 supplying power to a TFT circuit of the TFT layer 11 and a TFT circuit on a rear surface of the glass substrate 10 and electrically connecting a circuit (not shown) electrically connected to a separate control substrate.

The TFT substrate 12 includes an active area 11a that displays an image on a front surface and a dummy area 11b that cannot display an image.

The active area 11a may be divided into a plurality of pixel areas 13 in which a plurality of pixels are arranged. The plurality of pixel areas 13 may be divided in various shapes, and may be divided in a matrix form, for example. Each pixel area 13 may include a sub-pixel area in which multi-color micro LEDs, which generate a plurality of sub-pixels, are mounted, and a pixel circuit area in which a pixel circuit for driving each sub-pixel is disposed.

A plurality of micro LEDs 20 are transferred to the pixel area of the TFT layer 11, and electrodes of the micro LEDs may be electrically connected to TFT electrodes formed in the pixel area of the TFT layer 11, respectively. A common electrode pad may be formed in a single straight line in consideration of the arrangement of the three micro LEDs 20 arranged side by side. The plurality of micro LEDs may be sub-pixels constituting a single pixel. In the disclosure, one micro LED refers to one sub-pixel.

A pixel driving method of the display module 1 according to an embodiment of the disclosure may be an active matrix (AM) driving method or a passive matrix (PM) driving method. The display module 1 may have a wiring pattern to which each micro LED is electrically connected according to the AM driving method or the PM driving method.

The dummy area 11b may be included in an edge region of the glass substrate 10. For example, in an embodiment, the edge region may be a region in which a plurality of side wirings are formed, and may include a first region corresponding to a side surface of the glass substrate 10, a second region corresponding to a portion of a front surface of the glass substrate 10 adjacent to the side surface of the glass substrate 10, and a third region corresponding to a portion of a rear surface of the glass substrate 10 adjacent to the side surface of the glass substrate 10.

The plurality of first connection pads 8a may be disposed at regular intervals in the second region. The plurality of first connection pads 8a may be electrically connected to the sub-pixels through wirings 8b, respectively.

A plurality of second connection pads (not shown) may be disposed at regular intervals in the third region. Each of the plurality of second connection pads may be electrically connected to a circuit disposed on the rear surface of each glass substrate through wirings (not shown).

A plurality of side wirings 30 for electrically connecting a plurality of first and second connection pads are formed in the edge region of the glass substrate 10. For example, one first connection pad and one second connection pad may correspond to one side wiring 30. Accordingly, one end of the one side wiring 30 is electrically connected to one first connection pad formed on the glass substrate 10 before the side wiring 30, and the other end of the one side wiring 30 is electrically connected to one second connection pad formed on the glass substrate 10 before the side wiring 30.

The number of first and second connection pads formed in the dummy area 11b may vary depending on the number of pixels and may vary according to a driving method of the TFT circuit disposed in the active area 11a. For example, compared to the case of the PM driving method in which a TFT circuit disposed in the active area 11a drives a plurality of pixels in a horizontal line and a vertical line, the AM driving method driving each pixel individually may use more wirings and connection pads.

FIG. 2 is a view illustrating an example arrangement of a plurality of sub-pixels mounted in a pixel area shown in FIG. 1.

Referring to FIG. 2, one pixel may be provided in one pixel area 13. One pixel may include at least two or more sub-pixels 20. In the example shown in FIG. 2, three R, G, and B sub-pixels 20 are included.

In addition, a plurality of TFT electrodes 31 and 33 electrically connected to the electrodes 21 and 23 provided in each of the micro LEDs 20 may be formed in one pixel area 13. As shown in FIG. 2, if there are three sub-pixels 20 in one pixel area, six TFT electrodes 31 and 33 may be provided.

The plurality of TFT electrodes 31 and 33 are covered by an anti-reflection layer 15 having a black color, but the plurality of sub-pixels 20 are not covered by the anti-reflection layer 15. In this case, since the anti-reflection layer 15 covers the TFT electrodes 31 and 33, which are metal materials with high reflectance, it is possible to prevent external light from being reflected by the TFT electrodes 31 and 33 in advance.

In addition, although the entire TFT layer 11 including the plurality of TFT electrodes 31 and 33 is covered by the anti-reflection layer 15, the sub-pixels 20 having a size of 100 µm or less are not covered by the anti-reflection layer 15. Accordingly, an aperture ratio for one pixel area may be minimized, and thus, the area for absorbing external light may be maximized to minimize reflection of external light.

The plurality of TFT electrodes 31 and 33 may be formed to have a length (refer to FIG. 2) so that two sub-pixels (e.g., a defective sub-pixel and a substituting sub-pixel) per a pair of TFT electrodes 31 and 33 are simultaneously connected so that the substituting sub-pixel may be electrically connected when a sub-pixel is defective. In this case, a portion of the anti-reflection layer 15 is peeled off so that a portion of the TFT electrodes 31 and 33 corresponding to a region in which the substituting sub-pixel is to be disposed is exposed, and then the substituting sub-pixel may be electrically connected to the TFT electrodes 31 and 33.

The micro LED 20 may be a semiconductor chip formed of an inorganic light emitting material and capable of emitting light by itself when power is supplied. The micro LED 20 may have a predetermined thickness and may be formed to have a square having the same width and length, or a rectangle having different widths and lengths as shown in FIG. 2. Such a micro LED may realize real high dynamic range (HDR), improve luminance and black expression, and provide a high contrast ratio compared to OLED. The size of the micro LED may be 100 µm or less, or preferably, 30 µm or less. The micro LED 20 may have a flip chip structure in which a pair of electrodes 21 and 23 (e.g., an anode and a cathode) are formed on the same surface and a light emitting surface is formed on a side opposite to the electrodes 21 and 23.

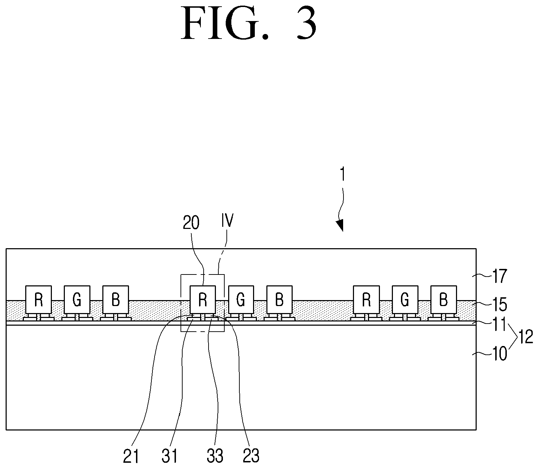

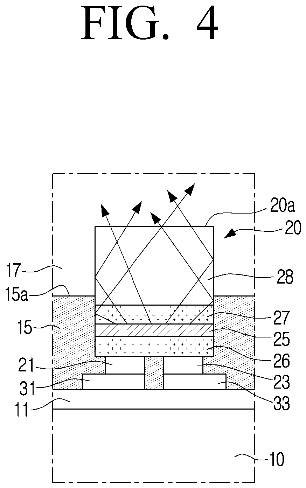

FIG. 3 is a cross-sectional view schematically illustrating a display module according to an embodiment of the disclosure, and FIG. 4 is an enlarged view illustrating a portion ₃ shown in FIG. 3.

Referring to FIG. 3, in the display module 1 according to an embodiment of the disclosure, an anti-reflection layer 15 covering a TFT layer 11 and a plurality of TFT electrodes 31 and 33 may be stacked.

Accordingly, with respect to the entire front surface of the TFT layer 11, a remaining area except for an area occupied by the plurality of micro LEDs 20 may be covered by the anti-reflection layer 15.

The anti-reflection layer 15 may be formed to have a light absorbing color, for example, a black-based color, to absorb external light irradiated to the display module 1, so that reflection of external light by the transparent TFT layer 11 and the plurality of TFT electrodes 31 and 33 formed of a metal material may be prevented or minimized.

The anti-reflection layer 15 may be an anisotropic conductive film (ACF) having a black-based color (hereinafter, `black ACF') by applying a dye or a pigment. The micro LED 20 is transferred to the TFT layer 11 after the anti-reflection layer 15 formed of the black ACF is attached on the TFT layer 11. The micro LED 20 transferred to the TFT layer 11 is pressed toward the TFT layer 11 in a thermocompression bonding process.

During the thermocompression bonding process, in the plurality of micro LEDs 20, a lower portion of the micro LED 20 including the electrodes 21 and 23 of the micro LED is drawn into the anti-reflection layer 15. The electrodes 21 and 23 of the micro LED are electrically connected to the corresponding TFT electrodes 31 and 33 in the anti-reflection layer 15.

The anti-reflection layer 15 may be formed of a non-conductive film (NCF) having a black-based color (hereinafter, "black NCF") by applying a dye or a pigment instead of a black ACF.

Referring to FIG. 4, as the micro LED 20 is pressed by the thermocompression bonding process, the lower portion of the micro LED including the electrodes 21 and 23 of the micro LED may be buried in the anti-reflection layer 15. In this case, an upper portion of the plurality of micro LEDs 20 including the light emitting surface (the surface opposite to the surface on which the electrodes are formed) may protrude from an upper surface of the anti-reflection layer 15 by a predetermined height. A light emitting surface 20a of the micro LED is disposed at a position higher than an upper surface 15a of the anti-reflection layer, but an active layer 25 of the micro LED 20 may be at a position lower than the upper surface 15a of the anti-reflection layer.

In addition, a portion of the anti-reflection layer 15 may fill a space between the electrodes 21 and 23 of the micro LED and the TFT electrodes 31 and 33.

Since the plurality of micro LEDs 20 are maintained in a shape in which a lower portion thereof is inserted (or buried) in the anti-reflection layer 15, the plurality of micro LEDs 20 may be fixed in place by the anti-reflection layer 15 by viscosity of the anti-reflection layer 15 or as the anti-reflection layer 15 is hardened. Accordingly, the electrical connection between the electrodes 21 and 23 of the micro LED and the TFT electrodes 31 and 33 may be stably maintained.

Most of light generated from the active layer 25 of the micro LED is emitted through the light emitting surface 20a as shown in FIG. 4, and light emitted laterally from the active layer 25 of the micro LED is blocked by the anti-reflection layer 15. Accordingly, the display module 1 may minimize mixing of light emitted from the micro LEDs disposed adjacent to each other even without a separate black matrix.

The anti-reflection layer 15 need not be limited to the black ACF or black NCF described above. For example, the anti-reflection layer 15 may be formed of a resin having a black-based color (hereinafter, "black resin") having a predetermined thickness. In this case, the black resin may be an insulator.

The anti-reflection layer 15 formed of black resin, for example, may be sequentially subjected to a photoresist process, exposure and development processes, and the TFT layer 11 except for a portion of each of the TFT electrode 31 and 33 may be coated with the black resin. Here, a portion of each of the TFT electrodes 31 and 33 refers to a portion not covered by the black resin for electrical connection with the electrodes 21 and 23 of the micro LED.

In addition to the photoresist process, the anti-reflection layer 15 formed of black resin may be formed on the TFT layer 11 by using a thin film coating technology such as a silk screen printing process, an inkjet process, a spin coating process, etc.

As described above, the anti-reflection layer 15 formed of black resin may have a thickness such that an upper surface 15a thereof is disposed at a position higher than the active layer 25 of the micro LED as shown in FIG. 4.

Meanwhile, in the disclosure, the active layer 25 of the micro LED 20 may be disposed between the first and second semiconductor layers 26 and 27 as shown in FIG. 4. A pair of electrodes 21 and 23 (e.g., anode and cathode electrodes) may be disposed on a bottom surface of the first semiconductor layer 26 of the micro LED 20, and a current diffusion layer 28 having a light emitting surface 20a may be stacked on an upper surface of the second semiconductor layer 27.

Although not shown in the drawing, the micro LED 20 may have a passivation layer (not shown) on the side of the micro LED 20 positioned between a surface on which the pair of electrodes 21 and 23 is located and the light emitting surface 20a. The passivation layer (not shown) may protect the side surface of the micro LED and reflect light emitted from the active layer 25 to be guided to the light emitting surface 20a of the micro LED.

Hereinafter, a method of manufacturing a display module according to an embodiment of the disclosure will be described.

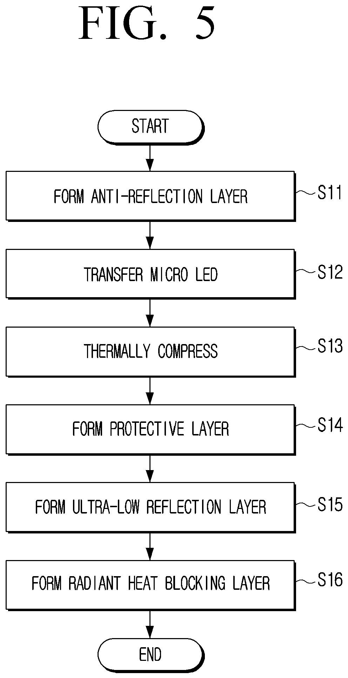

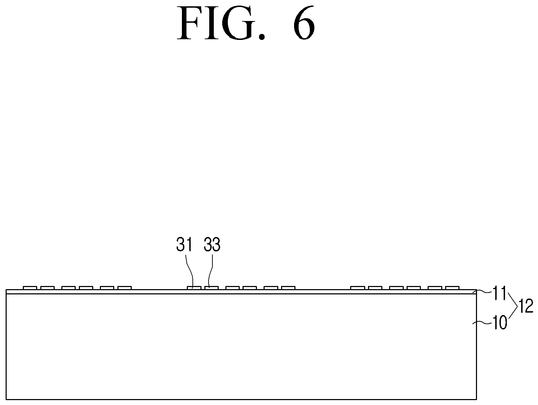

FIG. 5 is a flowchart illustrating a manufacturing process of a display module according to an embodiment of the disclosure, and FIGS. 6 to 12 are views schematically illustrating example operations of a manufacturing process of a display module according to an embodiment of the disclosure.

First, as shown in FIG. 6, the TFT substrate 12 in which the TFT layer 11 is stacked on one surface of the glass substrate 10 is prepared.

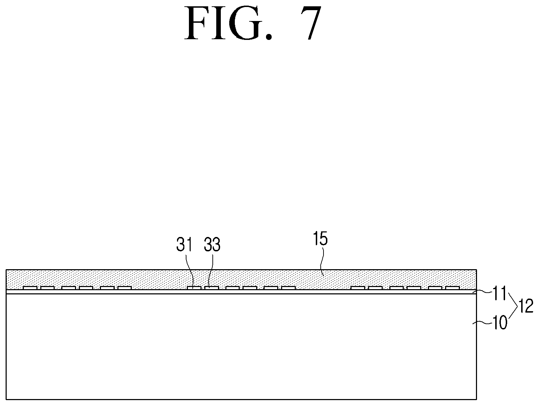

Referring to FIG. 7, the anti-reflection layer 15 having a black color is stacked on the entire upper surface of the TFT substrate 12 (S11). In this case, the anti-reflection layer 15 may be formed of black ACF.

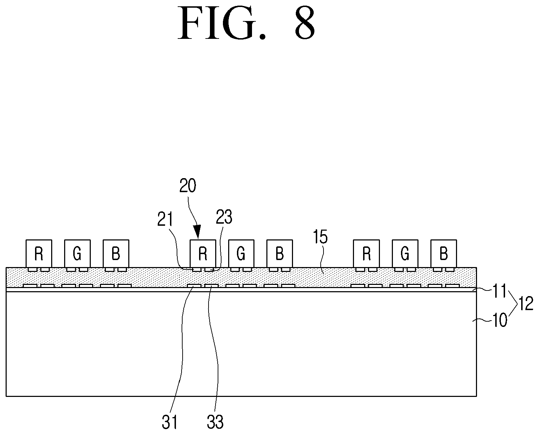

Referring to FIG. 8, a plurality of micro LEDs 20 are transferred to the TFT substrate 12 (S12).

Each micro LED 20 may be transferred from a carrier substrate (not shown) onto an upper surface of the anti-reflection layer 15 by, for example, a laser lift-off (LLO) method. In this case, the electrodes 21 and 23 of the micro LED may be maintained to be spaced apart from the corresponding TFT electrodes 31 and 33 by a predetermined interval (approximately an interval corresponding to the thickness of the anti-reflection layer 15).

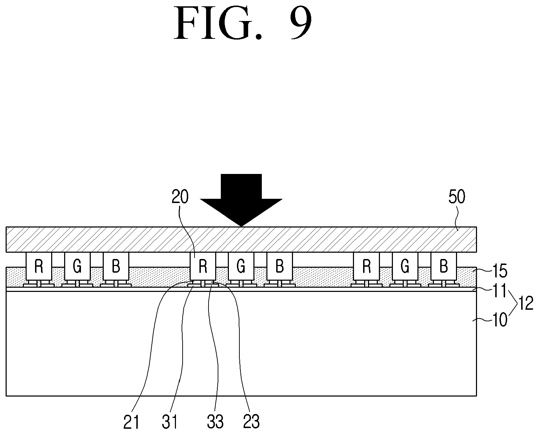

Referring to FIG. 9, a plurality of micro LEDs 20 are thermally compressed to the TFT layer 11 using a pressing member 50 (S13).

In this case, a die (not shown) on which the TFT substrate 12 is mounted heats the TFT substrate 12 to a temperature range in which the TFT substrate 12 is not damaged, thereby establishing an environment in which the electrodes 21 and 23 of the micro LED and the TFT electrodes 31 and 33 corresponding thereto are firmly connected to each other.

Accordingly, each micro LED 20 is pressed toward the TFT layer 11 by the pressing member 50 so that the electrodes 21 and 23 of the micro LED are electrically connected to the corresponding TFT electrodes 31 and 33, respectively.

Thereafter, each micro LED 20 may be encapsulated using a molding layer. Although not shown in the drawings, the molding layer may be stacked on the anti-reflection layer 15 and the plurality of micro LEDs 20 similarly to the protective layer 17. As the molding layer, an optically clear adhesive (OCA) or a pressure sensitive adhesive (PSA) formed of silicone or epoxy may be used. When the molding layer covering the anti-reflection layer 15 and the plurality of micro LEDs 20 is formed, a protective layer 17 may be stacked on the molding layer. The molding layer may perform an adhesion function for bonding between the TFT substrate 12 and the protective layer 17 in the stacking process of the protective layer 17.

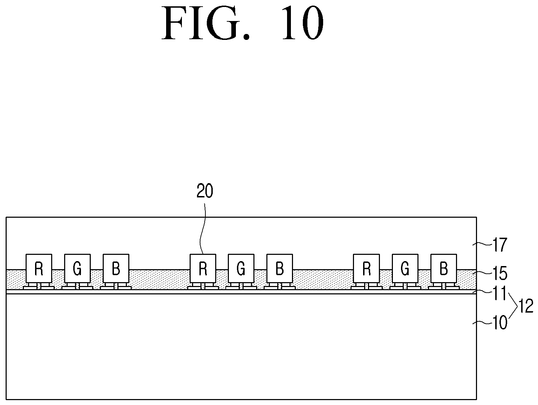

Referring to FIG. 10, the protective layer 17 is stacked to protect the micro LED 20 encapsulated by the encapsulating member from external impact (S14).

The protective layer 17 may be formed of a transparent film or transparent glass having a predetermined thickness. When the process of stacking the protective layer 17 is completed in this manner, a display module 1 may result.

In the display module 1 formed as described above, the remaining area except for the area occupied by each sub-pixel in the entire area of the TFT layer 11 may be blacked by the anti-reflection layer 15 having a black color. In this case, since the TFT electrodes 31 and 33 (refer to FIG. 2) formed to have an extra length to mount the substituting micro LED are not exposed and are covered by the anti-reflection layer 15, reflection of external light on the electrodes 31 and 33 may fundamentally blocked. Accordingly, the display module 1 according to an embodiment of the disclosure may have an improved display contrast ratio.

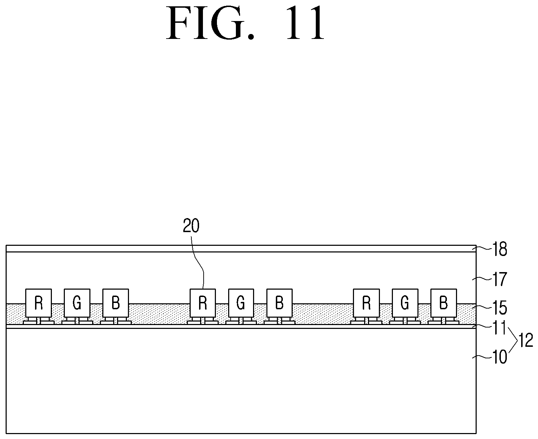

Meanwhile, referring to FIG. 11, the display module 1 according to an embodiment of the disclosure may have an ultra-low reflection layer 18 stacked on the protective layer 17 to further reduce reflection of external light (S15).

The ultra-low reflection layer 18 serves as anti-reflection and anti-glare and may be formed of, for example, any one of polyethylene terephthalate (PET), polyethylene naphthalate (PEN), cyclo-olefin polymer (COP), and tri-acetyl cellulose (TAC) film.

In addition, as the size of the displays increases, radiant heat generated by the display device may be transmitted to the user.

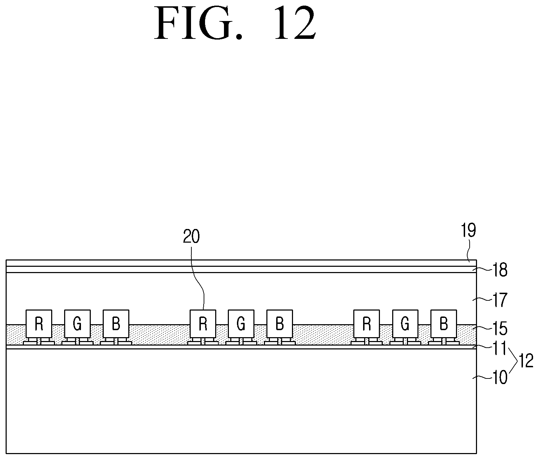

In order to block such radiant heat, as shown in FIG. 12, a radiant heat blocking layer 19 for blocking near infrared (NIR) and far infrared (FIR) may be additionally stacked on the ultra-low reflection layer 18 (S16).

In this case, in order to minimize transmittance loss due to the radiant heat blocking layer 19, a material of the radiant heat blocking layer 19 may be Ag and may be formed as a thin film having a thickness of about 5 µm.

As described above, when the protective layer 17 and the molding layer covering the anti-reflection layer 15 and the plurality of micro LEDs 20 are stacked, the ultra-low reflection layer 18 may be stacked on the protective layer 17, and the radiant heat blocking layer 19 may be stacked on the ultra-low reflection layer 18.

Meanwhile, the TFT substrate 12 (or the glass substrate 10) is aligned in posture several times in the micro LED transfer process and subsequent processes. In this case, an alignment mark marked on the TFT substrate 12 may be checked through a vision camera (not shown), and the TFT substrate 12 may be aligned using the alignment mark as a reference.

However, the alignment mark is marked on the TFT substrate 12 before the anti-reflection layer 15 having a black-based color is formed on the TFT substrate 12. Accordingly, when the remaining regions except for each sub-pixel in the TFT layer 11 are blackened by the anti-reflection layer 15, it may be difficult to recognize the alignment mark formed on the TFT substrate 12 through a vision camera (not shown) in the micro LED transfer process and subsequent processes.

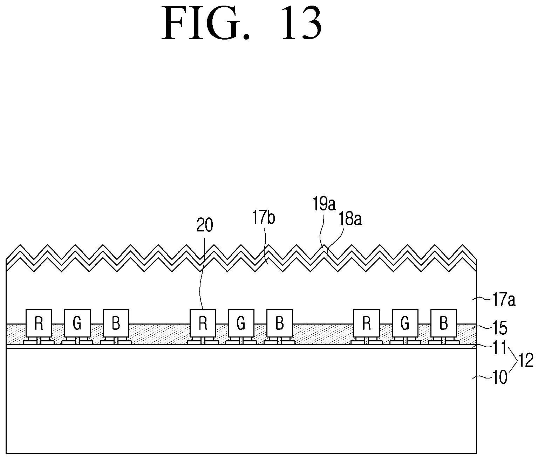

FIG. 13 is a view illustrating an example in which a plurality of diffuse reflection protrusions are formed in order to maximize an anti-reflection effect.

Referring to FIG. 13, beads or a plurality of diffuse reflection protrusions 17b may be formed on an upper surface of the protective layer 17a through an imprinting process.

The protective layer 17a having a rough surface formed by the plurality of diffuse reflection protrusions 17b diffusely reflects external light to maximize the anti-reflection effect. The plurality of diffuse reflection protrusions 17b may be formed in a regular pattern or irregularly.

An ultra-low reflection layer 18a may be stacked on the plurality of diffuse reflection protrusions 17b. In this case, a concave-convex shape may be formed along the plurality of diffuse reflection protrusions 17b. The radiant heat blocking layer 19a may be stacked on the ultra-low reflection layer 18a having an uneven shape, and may have an uneven shape like that of the ultra-low reflection layer 18a.

Although not shown in the drawing, the display module shown in FIG. 13 may further include a molding layer. In this case, the protective layer 17a may be stacked on the molding layer stacked on the anti-reflection layer 15 and the plurality of micro LEDs 20.

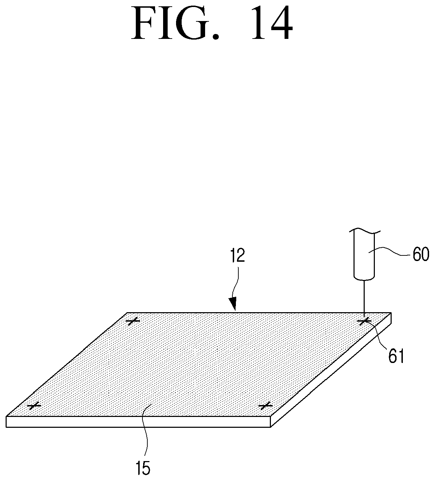

FIG. 14 is a view illustrating an example of forming fine alignment marks on an anti-reflection layer with a laser beam.

Referring to FIG. 14, a portion of the anti-reflection layer 15 may be removed with a laser beam through a laser irradiator 60 to expose an alignment mark 61 covered by the anti-reflection layer 15, so that the alignment mark 61 of the TFT substrate 12 may be imaged by a vision camera.

As another example, when the alignment mark 61 is not marked on the TFT substrate 12, a laser beam may be irradiated onto the anti-reflection layer 15 to pattern the shape of the alignment mark 61. As such, the alignment mark pattern formed on the anti-reflection layer 15 appears brighter than the anti-reflection layer 15, which is a black color, through the vision camera, and thus may be used as an alignment mark.

As another example, before the formation of the anti-reflection layer 15, transmittance of the anti-reflection layer 15 may be adjusted so that the vision camera may recognize the alignment mark 61 marked on the TFT substrate 12. In this case, the vision camera may be a camera capable of recognizing a visible light region.

As another example, the anti-reflection layer 15 may be formed by adding a black color pigment or dye that absorbs light in the visible spectrum and but is transparent in at least a region of the infrared spectrum. In this case, the vision camera may irradiate the TFT substrate 12 with infrared rays and recognize the alignment mark through reflected light. In this case, the vision camera may be an infrared camera or a visible light camera.

In the disclosure, the alignment mark of the TFT substrate 12 may be recognized through various methods, and the posture of the TFT substrate 12 may be aligned in the micro LED transfer process and subsequent processes.

In the above, various embodiments of the disclosure have been individually described, but each embodiment is not necessarily implemented alone, and a configuration and operation of each embodiment may be implemented in combination with at least one other embodiment.

In addition, although preferred embodiments of the disclosure have been illustrated and described above, the disclosure is not limited to the specific embodiments described above, and the technical field to which the disclosure pertains without departing from the gist of the disclosure as claimed in the claims Various modifications may be made by those of ordinary skill in the art, and these modifications should not be individually understood from the technical spirit or perspective of the disclosure.

### [INDUSTRIAL APPLICABILITY]

The disclosure relates to a display module and a manufacturing method therefor.

## Claims

1. A display module comprising:
a substrate;
a thin film transistor (TFT) layer stacked on a surface of the substrate, and on which a plurality of TFT electrodes are arranged on the TFT layer;
a plurality of light emitting devices (LEDs) electrically connected to the plurality of TFT electrodes;
an anti-reflection layer stacked on the TFT layer, the anti-reflection layer having a light absorption color for absorbing external light, the anti-reflection layer fixing in place the plurality of LEDs; and
a protective layer stacked on the anti-reflection layer and the plurality of LEDs,
wherein the plurality of TFT electrodes and the plurality of LEDs are electrically connected in the anti-reflection layer.

2. The display module as claimed in claim 1, wherein the anti-reflection layer is formed by applying a black-based pigment or dye to an anisotropic conductive film (ACF).

3. The display module as claimed in claim 1, wherein the anti-reflection layer is formed by applying a black-based pigment or dye to a non-conductive film (NCF).

4. The display module as claimed in claim 1, wherein the anti-reflection layer is formed of a black resin.

5. The display module as claimed in claim 1, wherein
the plurality of LEDs have a light emitting surface exposed to the outside of the anti-reflection layer.

6. The display module as claimed in claim 5, wherein
a portion of the plurality of LEDs in which the light emitting surface is formed protrudes from the anti-reflection layer.

7. The display module as claimed in claim 5, wherein:
each of the plurality of LEDs comprises a pair of LED electrodes formed on a lower portion opposite to an upper portion on which the light emitting surface is formed, and
the pair of LED electrodes is embedded in the anti-reflection layer together with the plurality of TFT electrodes.

8. The display module as claimed in claim 1, further comprising a molding layer covering the anti-reflection layer and the plurality of LEDs,
wherein the protective layer is stacked on the molding layer.

9. The display module as claimed in claim 1, further comprising:
an ultra-low reflection layer stacked on the protective layer; and
a radiant heat blocking layer stacked on the ultra-low reflection layer to block near-infrared and far-infrared rays.

10. The display module as claimed in claim 1, wherein the protective layer has a plurality of diffuse reflection protrusions formed on a surface thereof.

11. A display module comprising:
a thin film transistor (TFT) substrate;
an anti-reflection layer stacked on the TFT layer and having a black-based color;
a plurality of LEDs each respectively electrically connected to a corresponding one of the plurality of TFT electrodes of the TFT layer through the anti-reflection layer; and
a molding layer stacked on the anti-reflection layer and the plurality of LEDs,
wherein each of the plurality of LEDs comprises:
a light emitting surface formed on an upper portion thereof, and
a pair of LED electrodes disposed on a lower portion opposite to the upper portion and electrically connected to a corresponding pair of TFT electrodes, among the plurality of TFT electrodes, in the anti-reflection layer.

12. The display module as claimed in claim 11, further comprising:
a protective layer stacked on the anti-reflection layer and the plurality of LEDs; and
an ultra-low reflection layer stacked on the protective layer.

13. The display module as claimed in claim 12, further comprising a radiant heat blocking layer stacked on the ultra-low reflection layer to block near-infrared and far-infrared rays.

14. The display module as claimed in claim 12, wherein the protective layer has a plurality of diffuse reflection protrusions formed on a surface thereof.

15. A method of manufacturing a display module, the method comprising:
stacking an anti-reflection layer having a black-based color on a thin film transistor (TFT) layer formed on a substrate;
transferring a plurality of LEDs to the TFT layer;
thermally compressing the plurality of LEDs toward the TFT layer to respectively electrically connect electrodes of the plurality of LEDs to corresponding TFT electrodes provided on the TFT layer, a pair of electrodes of each of the plurality of LEDs being thereby inserted into the anti-reflection layer and electrically connected to the TFT electrode, the plurality of LEDs being thereby fixed in place by the anti-reflection layer;
covering the plurality of LEDs with an adhesive encapsulating member; and
stacking a protective layer on the plurality of LEDs and the anti-reflection layer.
